Europäisches Patentamt

European Patent Office

Office européen des brevets

(11) Veröffentlichungsnummer: **0 417 797 A2**

# EUROPÄISCHE PATENTANMELDUNG

(21) Anmeldenummer: 90117680.0

(51) Int. Cl.⁵: **B60R 13/04**

(22) Anmeldetag: **13.09.90**

(30) Priorität: **14.09.89 DE 3930830**

(43) Veröffentlichungstag der Anmeldung:
**20.03.91 Patentblatt 91/12**

(84) Benannte Vertragsstaaten:
**DE ES**

(71) Anmelder: **Trier, Lothar**
**Sudetenstrasse 1**
**W-8626 Michelau(DE)**

(72) Erfinder: **Trier, Lothar**
**Sudetenstrasse 1**
**W-8626 Michelau(DE)**

(74) Vertreter: **Prechtel, Jörg et al**
**Patentanwälte H. Weickmann, Dr. K. Fincke**
**F.A. Weickmann, B. Huber Dr. H. Liska, Dr. J.**
**Prechtel Möhlstrasse 22 Postfach 860 820**
**W-8000 München 86(DE)**

(54) **Korrosionsgeschützte Zierleiste.**

(57) Bei einer Schutz- und/oder Zierleiste mit einer metallisch wirkenden Oberfläche, insbesondere für Kraftfahrzeuge, mit einem Zierleisten-Trägerteil , dessen Oberfläche ganz oder teilweise mit einem Haftvermittlersystem versehen ist, das wiederum eine Metallbedampfungsschicht trägt, ist die Metallbedampfungsschicht auf die dem Trägerteil zugewandte Innenseite einer Folie aus einem glasklaren, lichtund witterungsbeständigen Kunststoff aufgedampft. Zur Herstellung einer erfindungsgemäßen Schutz- und/oder Zierleiste bedampft man eine Folie aus einem glasklaren, licht- und witterungsbeständigen Kunststoff mit einer Metallschicht und bringt die Folie mittels eines Haftvermittlersystems am Trägerteil an.

EP 0 417 797 A2

# KORROSIONSGESCHÜTZTE ZIERLEISTE

Die Erfindung betrifft Schutz- und/oder Zierleisten mit einer metallisch wirkenden Oberfläche, insbesondere für Kraftfahrzeuge, mit einem Zierleisten-Trägerteil, dessen Oberfläche ganz oder bereichsweise mit einem Haftvermittlersystem versehen ist, das wiederum eine Metallbedampfungsschicht trägt und ein Verfahren zu ihrer Herstellung.

Bislang verwendete Zierleisten bestanden meist aus einem Edelstahlband, jedoch ergab sich hier der Nachteil, daß vor allem im Randbereich Korrosionsschäden, insbesondere sogenannte Spalt-Korrosion auftrat, wenn nicht unwirtschaftlich teurer Stahl erhöhter Qualität verwendet wurde. Vor allem durch Straßenbehandlungsmittel wie Streusalze ergab sich mit Edelstahl-Zierleisten eine erhöhte Korrosion. Es wurde bereits versucht, Zierleisten herzustellen, die aufgrund einer Umhüllung mit Plastikmaterialien korrosionsgeschützt sein sollten. Hierzu wurden beispielsweise Kunststoffleisten hergestellt, die aus einem gewalzten Aluminiumband mit einer über Haftlack befestigten CAB-(Cellulose-Acetobutyrat)-Umhüllung bestehen. Jedoch weisen solche Kunststoffleisten den Nachteil auf, daß bei Eindringen von Feuchtigkeit am freien Leistenende Korrosion des Aluminiums der Aluminiumfolie auftritt. Außerdem ist CAB hygroskopisch, so daß auch im Abstand von den Leistenenden Aluminium-Korrosion auftreten kann mit der Folge, daß die Aluminiumfolie "blind" wird.

Weiter wurden Kunststoffleisten hergestellt, die aus aluminiumbedampfter Polyesterfolie, die auf der Aluminiumseite mit einer PVC-Folie verklebt ist, bestehen und mit transparentem Kunststoff, z.B. PVC, umspritzt sind. Hierbei ist jedoch zur Vermeidung der Korrosion der Aluminiumschicht bei Salzberührung eine Versiegelung notwendig, die in vielen Fällen nicht ausreichend zuverlässig ist. Die auf der Betrachterseite gelegene Polyesterfolie hingegen ist nicht lichtbeständig, wodurch das Aussehen der Zierleiste beeinträchtigt wird.

Weiter sind Zierleisten bekannt, die aus einem Zierleisten-Träger bestehen, auf den eine Polyesterfolie, die zuerst mit einer Lackschicht und dann mit einer Chrombedampfung versehen ist, über eine Heißsiegellackschicht aufgetragen wird. Die Chromschicht wird beim Andrücken der Folie unter Wärmeanwendung auf den Zierleisten-Träger aufgeschweißt und anschließend die Polyesterfolie abgezogen. Die Chromschicht als solche ist witterungsbeständig, jedoch sind die auf diese Weise hergestellten Chromzierstreifen nicht kratzfest und die Leisten daher allenfalls im Kraftfahrzeug-Innenraum einsetzbar.

Der Erfindung lag daher die Aufgabe zugrunde, eine Zierleiste bereitzustellen, welche auf wirtschaftliche Weise die obengenannten Nachteile des Standes der Technik, nämlich die Korrosion des Metalls, bzw. die ungenügende Kratzfestigkeit und Witterungsbeständigkeit, vermeidet.

Gelöst wird diese Aufgabe erfindungsgemäß durch Schutzund/oder Zierleisten mit einer metallisch wirkenden Oberfläche, insbesondere für Kraftfahrzeuge, mit einem Zierleisten-Trägerteil, dessen Oberfläche ganz oder bereichsweise mit einem Haftvermittlersystem versehen ist, das wiederum eine Metallbedampfungsschicht trägt, welche dadurch gekennzeichnet sind, daß die Metallbedampfungsschicht auf die dem Trägerteil zugewandte Innenseite einer Folie aus einem Polymerisat aus einem glasklaren, licht- und witterungsbeständigen Kunststoff aufgedampft ist.

Die erfindungsgemäß verwendete Folie kann aus jeglichem geeigneten Kunststoff bestehen, sofern dieser witterungsund lichtbeständig ist. Als besonders beständig können hier z.B. die Polymerisate aus fluorierten Kohlenwasserstoffmonomeren angesehen werden. In bevorzugten Ausführungsformen der Erfindung besteht die Folie aus Polyvinylidenfluorid (PVDF), Polytetrafluorethylen (PTFE) oder Polymethylmethacrylat (PMMA), oder einem Copolymer von mindestens zwei der entsprechenden Monomere oder einem Copolymer oder Verschnitt mindestens eines der Monomere mit einem anderen lichtbeständigen Werkstoff.

Diese Folie, welche die Metallbedampfungsschicht trägt, ist über ein Haftvermittlersystem an dem ZierleistenTrägerteil befestigt. Als Haftvermittlersystem sind z.B. Haftlacke oder auch spezielle Kunststoff-Folien geeignet, die nach Druck- und/oder Wärmeeinwirkung eine Verbindung mit dem Trägerteil eingehen können.

Als Zierleisten-Trägerteilmaterial sind harte oder auch weiche Materialien geeignet, die zusätzlich noch mit Metallbändern oder Profilen armiert sein können. Vorzugsweise werden harte Plastikmaterialien verwendet, da diese im Gegensatz zu Metallteilen keine Korrosion zeigen. Geeignete Materialien hierfür sind beispielsweise PVC (Polyvinylchlorid), ABS (Acrylnitril-Butadien-Styrol-Copolymer) oder Polyolefine usw.

Für den Fall, daß das Trägerteil aus einem weichen Material besteht, ist es bevorzugt, dieses weiche Material im Bereich der Folie mit einer harten Zwischenlage zu versehen, damit ein Durchdrücken der Folie beim Aufbringen und/oder bei der bestimmungsgemäßen Anwendung durch mechanische Druckeinwirkung verhindert wird.

Die Metallbedampfung kann aus jedem Metall, das durch den Angriff korrodierend wirkender Medien in seiner Oberfläche optisch nicht verändert wird, bestehen, z.B. Gold oder Chrom, wobei Chrom erfindungsgemäß bevorzugt ist.

In einer weiteren bevorzugten Ausführungsform der Erfindung befindet sich zwischen der Metallbedampfungsschicht und der Folie eine Zwischenschicht, z.B. eine Lackschicht, die die Haftfestigkeit der Metallbedampfungsschicht erhöht.

Erfindungsgemäß liegt also die Folie an der Außenseite der Leiste. Die Folie ist glasklar, witterungsbeständig und kratzfest, die bevorzugte Chrombedampfung korrosionsfrei und ändert ihre Optik nicht, wenn aggressive Medien aus der Umwelt, UV-Licht und Wetter ein-wirken. Die sich ergebende Zierleiste ist leicht und kostengünstig herstellbar und benötigt keine besonderen Versiegelungsmaßnahmen. Der Chromglanz bleibt dauerhaft erhalten.

Ein weiterer Gegenstand der Erfindung ist ein Verfahren zur Herstellung einer erfindungsgemäßen Schutz- und/oder Zierleiste. Dieses Verfahren ist dadurch gekennzeichnet, daß man eine Folie aus glasklarem, licht- und witterungsbeständigem Kunststoff mit einer Metallschicht bedampft und die Folie mittels des Haftvermittlersystems am Trägerteil anbringt.

Bevorzugt versieht man vor dem Anbringen der Folie am Trägerteil die Seite der Folie, auf der die Metallbedampfung liegt, mit einem Haftvermittlungssystem.

In einer bevorzugten Ausführungsform der Erfindung verwendet man eine Folie aus PVDF, PTFE oder PMMA bzw. einem Copolymer der entsprechenden Monomere oder aus einem Copolymer oder Verschnitt mindestens eines der Monomere mit einem anderen lichtbeständigen Werkstoff. Als Metallbedampfung verwendet man vorzugsweise Chrom.

Das Trägerteilmaterial kann, wie bereits oben ausgeführt, aus einem harten oder weichen Material bestehen.

In einer bevorzugten Ausführungsform verwendet man ein hartes Trägermaterial, während man in einer anderen bevorzugten Ausführungsform der Erfindung ein weiches Trägerteilmaterial verwendet und dieses im Bereich der Folie mit einer harten Zwischenlage versieht. In einer dritten bevorzugten Ausführungsform verwendet man einen metallarmierten Kunststoff für das Trägerteil.

In einer weiteren bevorzugten Ausführungsform bringt man vor der Bedampfung mit der Metallschicht auf die Folie eine Zwischenschicht auf, die die Haftfestigkeit der Metallschicht erhöht, wie z.B. eine Lackschicht.

Vorzugsweise bringt man die mit der Bedampfung und auch bereits der Haftlackschicht versehene Folie bei der Extrusion des Trägerteils auf. Hierdurch ergibt sich die Möglichkeit, die erfindungsgemäßen Schutz- und Zierleisten nach Bedampfung der Folie in nur einem weiteren Arbeitsgang fertigzustellen.

Einige Ausführungsbeispiele der Erfindung sind in der Zeichnung dargestellt und werden im folgenden näher beschrieben.

Fig. 1 zeigt eine erfindungsgemäße Zierleiste mit einem Trägerteil 2, auf dem über eine Haftlackschicht 4 eine Folie 8, welche auf der dem Trägerteil zugewandten Seite eine Metallbedampfungsschicht 6 aufweist, befestigt ist. Die Folie mit der Metallbedampfung bedeckt hierbei nur einen Teil des Trägermaterials, wodurch sich eine zweifarbige Zierleiste ergibt.

Fig. 2 zeigt eine ähnliche Zierleiste wie Fig. 1, jedoch besteht das Trägerteil 2 aus einem weichen Material und ist in dem Bereich, auf den die bedampfte Folie 8 aufgebracht ist, mit einer harten Zwischenlage 10 versehen.

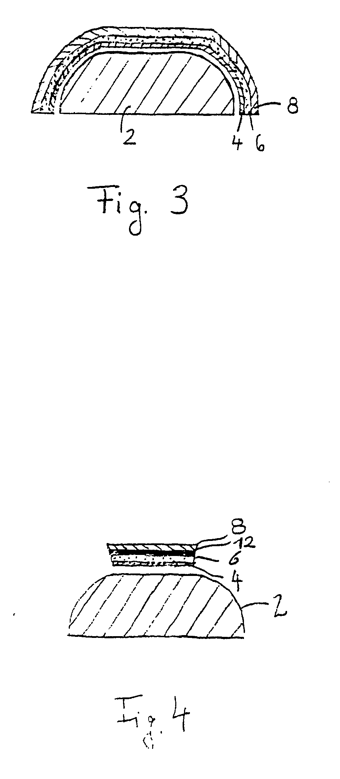

Fig. 3 zeigt ebenfalls eine ähnliche Zierleiste wie Fig. 1, jedoch ist, nach dem Anbringen an beispielsweise einem Autoteil, wie Türen oder Kotflügel, die gesamte sichtbare Oberfläche der Leiste mit der metallbedampften Folie überzogen.

Fig. 4 zeigt eine ähnliche Zierleiste wie Figur 1, bei der jedoch zwischen Folie 8 und Metallschicht 6 eine Zwischenschicht 12 aufgebracht ist, die die Haftfestigkeit der Metallbedampfung 6 erhöht.

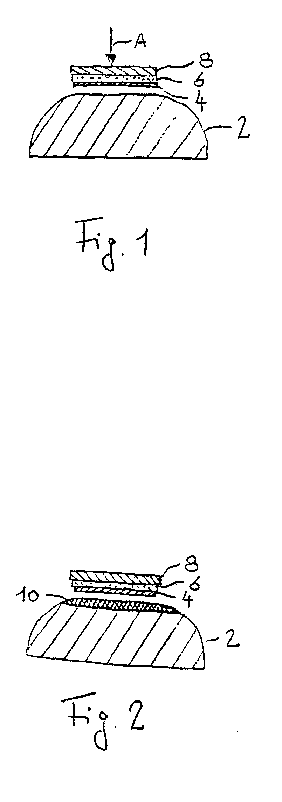

Bei der Herstellung der Zierleisten wird, wie durch die Pfeilrichtung A in Fig. 1 angedeutet, zuerst auf die Folie 8 das verwendete Metall aufgedampft - gegebenenfalls nach Aufbringen einer die Haftfestigkeit des Metalldampfes erhöhenden Zwischenschicht 12 -, dann auf die Bedampfungsschicht 6 eine Haftlackschicht 4 aufgetragen und schließlich die Folie 8 über diese Haftlackschicht 4 auf das Trägerteil durch Wärmeeinwirkung aufgeschweißt.

Erfindungsgemäß wird eine Zierleiste bereitgestellt, die gegenüber Witterungseinflüssen und Korrosion durch Straßenstreuprodukte beständig ist und ihren Metallglanz dauerhaft bewahrt. Die erfindungsgemäße Zierleiste ist außerdem äußerst kratzfest und kann leicht und kostengünstig hergestellt werden.

Die Erfindung, wie vorgehend beschrieben kann wie folgt zusammengefaßt werden:

Bei einer Schutz- und/oder Zierleiste mit einer metallisch wirkenden Oberfläche, insbesondere für Kraftfahrzeuge, mit einem Zierleisten-Trägerteil, dessen Oberfläche ganz oder teilweise mit einem HaftvermittlerSystem versehen ist, das wiederum eine Metallbedampfungsschicht trägt, ist die Metallbedampfungs schicht auf die dem Trägerteil zugewandte Innenseite einer Folie aus einem glasklaren, lichtund witterungsbeständigen Kunststoff aufgedampft. Zur Herstellung einer erfindungsgemäßen Schutz- und/oder Zierleiste bedampft man eine Folie aus einem glasklaren, licht- und witterungsbeständigen Kunststoff mit einer Metallschicht und bringt die Folie mittels eines Haftvermittlersystems am Trägerteil an.

**Ansprüche**

1. Schutz- und/oder Zierleiste mit einer metallisch wirkenden Oberfläche, insbesondere für Kraftfahrzeuge, mit einem Zierleisten-Trägerteil (2), dessen Oberfläche ganz oder teilweise mit einem Haftvermittlersystem (4) versehen ist, das wiederum eine Metallbedampfungsschicht (6) trägt, **dadurch gekennzeichnet,** daß die Metallbedampfungsschicht (6) auf die dem Trägerteil (2) zugewandte Innenseite einer Folie (8) aus einem glasklaren, licht- und witterungsbeständigen Kunststoff aufgedampft ist.

2. Schutz- und/oder Zierleiste nach Anspruch 1, **dadurch gekennzeichnet,** daß die Folie (8) aus Polyvinylidenfluorid (PVDF) besteht.

3. Schutz- und/oder Zierleiste nach Anspruch 1, **dadurch gekennzeichnet,** daß die Folie (8) aus Polytetrafluorethylen (PTFE) besteht.

4. Schutz- und/oder Zierleiste nach Anspruch 1, **dadurch gekennzeichnet,** daß die Folie (8) aus Polymethylmethacrylat (PMMA) besteht.

5. Schutz- und/oder Zierleiste nach Anspruch 1, **dadurch gekennzeichnet,** daß die Folie aus einem Copolymer von Vinylidenfluorid oder/und Tetrafluorethylen oder/und Methylmethacrylat oder einem Copolymer oder Verschnitt eines dieser Monomere mit einem anderen lichtbeständigen Werkstoff besteht.

6. Schutz- und/oder Zierleiste nach einem der Ansprüche 1 bis 5, **dadurch gekennzeichnet,** daß die Metallbedampfungsschicht (6) aus einem Metall besteht, dessen Oberfläche sich unter dem Einfluß korrodierend wirkender Medien optisch nicht verändert.

7. Schutz- und/oder Zierleiste nach Anspruch 6, **dadurch gekennzeichnet,** daß das Metall Chrom ist.

8. Schutz- und/oder Zierleiste nach einem der Ansprüche 1 bis 7, **dadurch gekennzeichnet,** daß das Trägerteil (2) aus einem harten Material gebildet ist.

9. Schutz- und/oder Zierleiste nach einem der Ansprüche 1 bis 7, **dadurch gekennzeichnet,** daß das Trägerteil (2) aus weichem Material gebildet ist, das im Bereich der Folie vorzugsweise mit einer harten Zwischenlage (10) versehen ist.

10. Schutz- und/oder Zierleiste nach einem der Ansprüche 1 bis 7, **dadurch gekennzeichnet,** daß das Trägerteil (2) aus einem metallarmierten Kunststoff gebildet ist.

11. Schutz- und/oder Zierleiste nach einem der Ansprüche 1 bis 10, **dadurch gekennzeichnet,** daß zwischen der Folie (8) und der Metallbedampfungsschicht (6) eine Zwischenschicht (12) vorhanden ist, die die Haftfestigkeit der Metallbedampfungsschicht (6) erhöht.

12. Verfahren zur Herstellung einer Schutz- und/oder Zierleiste nach einem der vorhergehenden Ansprüche, **dadurch gekennzeichnet,** daß man eine Folie aus einem glasklaren, lichtund witterungsbeständigen Kunststoff mit einer Metallschicht bedampft und die Folie mittels eines Haftvermittlersystems am Trägerteil anbringt.

13. Verfahren nach Anspruch 12, **dadurch gekennzeichnet,** daß man vor dem Anbringen der Folie am Trägerteil die Seite der Folie, auf der die Metallbedampfung liegt, mit dem Haftvermittlersystem versieht.

14. Verfahren nach Anspruch 12 oder 13, **dadurch gekennzeichnet,** daß man eine Folie aus Polyvinylidenfluorid (PVDF) verwendet.

15. Verfahren nach Anspruch 12 oder 13, **dadurch gekennzeichnet,** daß man eine Folie aus Polytetrafluorethylen (PTFE) verwendet.

16. Verfahren nach Anspruch 12 oder 13, **dadurch gekennzeichnet,** daß man eine Folie aus Polymethylmethacrylat (PMMA) verwendet.

17. Verfahren nach Anspruch 12 oder 13, **dadurch gekennzeichnet,** daß man eine Folie verwendet, die aus einem Copolymer von Vinylidenfluorid oder/und Tetrafluorethylen oder/und Methylmethacrylat oder einem Copolymer oder Verschnitt eines dieser Monomere mit einem anderen lichtbeständigen Werkstoff besteht.

18. Verfahren nach einem der Ansprüche 12 bis 17, **dadurch gekennzeichnet,** daß man zur Metallbedampfung ein Metall verwendet, dessen Oberfläche sich unter dem Einfluß korrodierend wirkender Medien optisch nicht verändert.

19. Verfahren nach Anspruch 18, **dadurch gekennzeichnet,** daß man Chrom verwendet.

20. Verfahren nach einem der Ansprüche 12 bis 19, **dadurch gekennzeichnet,** daß man für das Trägerteil ein hartes Material verwendet.

21. Verfahren nach einem der Ansprüche 12 bis 19, **dadurch gekennzeichnet,** daß man für das Trägerteil ein weiches Material verwendet und dieses im Bereich der Folie vorzugsweise mit einer harten Zwischenlage versieht.

22. Verfahren nach einem der Ansprüche 12 bis 19, **dadurch gekennzeichnet,** daß man für das Trägerteil einen metallarmierten Kunststoff verwendet.

23. Verfahren nach einem der Ansprüche 12 bis 22, **dadurch gekennzeichnet,** daß man vor der Bedampfung mit der Metallschicht auf die Folie eine Zwischenschicht aufbringt, die die Haftfestigkeit der Metallschicht erhöht.

24. Verfahren nach einem der Ansprüche 12 bis 23, **dadurch gekennzeichnet,** daß man die mit der Bedampfung und dem Haftvermittlersystem versehene Folie bei der Extrusion des Trägerteils auf dieses aufbringt.

Fig. 1

Fig. 2

Fig. 3

Fig. 4